Europäisches Patentamt

(19) European Patent Office

Office européen des brevets

(11) Numéro de publication : **0 036 791**
**B1**

(12) **FASCICULE DE BREVET EUROPÉEN**

(45) Date de publication du fascicule du brevet :
07.12.83

(51) Int. Cl.³ : **H 03 K 19/094**

(21) Numéro de dépôt : **81400271.3**

(22) Date de dépôt : **20.02.81**

(54) **Inverseur utilisant des transistors à effet de champ à faible tension de seuil et une diode de commutation.**

(30) Priorité : **21.03.80 FR 8006402**

(43) Date de publication de la demande :
**30.09.81 Bulletin 81/39**

(45) Mention de la délivrance du brevet :
**07.12.83 Bulletin 83/49**

(84) Etats contractants désignés :
**DE GB IT NL**

(56) Documents cités :
**FR-A- 2 264 434**
**US-A- 4 177 390**
**SUPPLEMENT TO THE JOURNAL OF THE JAPAN SOCIETY OF APPLIED PHYSICS: Proceedings of the 6th Conference on Solid State Devices, Tokyo, 1974, vol. 44, 1975 Tokyo, JP, SUZUKI et al.: "Logic Circuits with 2 micro gate Schottky barrier FETs", pages 219-224**
**IEEE TRANSACTIONS ON ELECTRONIC DEVICE⌐, vol. ED-16, no. 11, novembre 1969 New York, US, LIN et al.: "Complementary MOS-bipolar transistor structure", pages 945-951**

(73) Titulaire : **THOMSON-CSF**
**173, Boulevard Haussmann**
**F-75379 Paris Cedex 08 (FR)**

(72) Inventeur : **Bert, Georges**
**THOMSON-CSF SCPI 173, bld Haussmann**
**F-75360 Paris Cedex 08 (FR)**

(74) Mandataire : **Taboureau, James et al**
**THOMSON-CSF SCPI 173, Bld Haussmann**
**F-75379 Paris Cedex 08 (FR)**

Inverseur utilisant des transistors à effet de champ à faible tension de seuil et une diode de commutation

L'invention a pour but la réalisation, notamment en circuit intégré, d'un inverseur logique utilisant des transistors à effet de champ à faible tension de seuil ainsi qu'une diode de commutation.

On connaît de façon classique les transistors à effet de champ dits normalement conducteurs (« normally on » en anglais) et les transistors normalement bloqués (« normally off » en anglais). Les premiers sont bloqués par déplétion, nécessitant une alimentation à double polarité et présentant en outre l'inconvénient d'une consommation de courant électrique à l'état de repos. Les seconds laissent passer le courant quand on applique une tension appropriée à la grille de commande : ils ne nécessitent pas une alimentation à double polarité et sont plus économiques, mais par contre difficiles à réaliser, à cause de la très faible épaisseur du canal de conduction, en donnant lieu à un grand nombre de déchets de fabrication.

Une troisième catégorie de transistors à effet de champ, qui est intermédiaire entre les deux précédentes tout en se rapprochant de la deuxième, est constituée par les transistors quasi normalement bloqués : ils sont bloqués pour une tension de seuil $V_T$ qui peut être positive ou négative, ce qui signifie que l'on admet une certaine dispersion dans la fabrication collective de ces transistors qui est par exemple la suivante :

$$- 0,5 \leqslant V_T \leqslant 0,2 \text{ volt}.$$

Cette dernière catégorie est plus facile à fabriquer que la deuxième, mais plus difficile à utiliser. On sait réaliser notamment par la technique exposée dans le document N° FR-A-2 449 369 de la Demanderesse correspondant à la demande de brevet européen E.-P-A-21 858, des transistors à faible tension de seuil. Dans cette technique, on creuse, par érosion ionique, une tranchée entre la source et le drain, ce qui constitue une résistance saturable à très faible consommation, que l'on peut transformer en transistor à effet de champ en déposant une métallisation dans le fond de la tranchée à l'emplacement de la grille de commande et pour remplir la fonction. Toutefois, les résistances et transistors réalisés par cette technologie présentent une certaine dispersion et donc, certains inconvénients. En particulier :

1. Dans cette technologie, on réalise sur une même plaquette de circuit intégré des structures à canal creusé dont certaines forment les charges saturables des circuits logiques et d'autres, après métallisation de la tranchée, les transistors à effet de champ ; or, il est difficile, par suite de la dispersion des caractéristiques, d'obtenir une bonne reproductivité des circuits logiques ainsi réalisés.

2. En raison de la dispersion des caractéristiques, la tension de seuil est tantôt positive, tantôt négative ; dans le cas où elle est négative, le transistor d'entrée n'est pas bloqué, ce qui présente, outre un inconvénient du point de vue de la consommation, une diminution d'entrance, interdisant notamment la constitution d'entrées multiples, par exemple dans le cas de la réalisation de portes du type « ET NON ».

L'invention tend à éviter ces inconvénients en rendant le circuit capable de fonctionner avec une charge saturable classique et un niveau d'entrée bas provenant de la présence d'un grand nombre d'entrées.

L'inverseur logique selon l'invention telle que définie dans la revendication 1 ne comporte que des transistors à effet de champ de type quasi normalement bloqué à faible tension de seuil. Le signal d'entrée est appliqué sur la grille d'un transistor d'entrée, dont la source est reliée à la masse par l'intermédiaire d'un second transistor : la source du transistor d'entrée est connectée à la grille du second transistor dont la source est à la masse. Ainsi, le contact de grille du second transistor, qui est un contact Schottky, introduit entre la source du transistor d'entrée et la masse une tension de décalage, qui est celle de la diode Schottky du contact de grille du second transistor.

Par ailleurs, le transistor d'entrée est alimenté à travers une charge saturable qui, notamment en vue de faciliter l'intégration monolithique, est de préférence un transistor à effet de champ, dont la source et la grille sont court-circuitées. Le second transistor est alimenté, à travers une diode, soit par un troisième transistor à effet de champ du type quasi normalement bloqué à faible tension de seuil, dont la grille est commandée par le drain du transistor d'entrée, soit par une seconde diode montée entre le drain du transistor d'entrée et la première diode.

La sortie de l'inverseur logique à bas niveau d'entrée est prélevée sur le drain du second transistor.

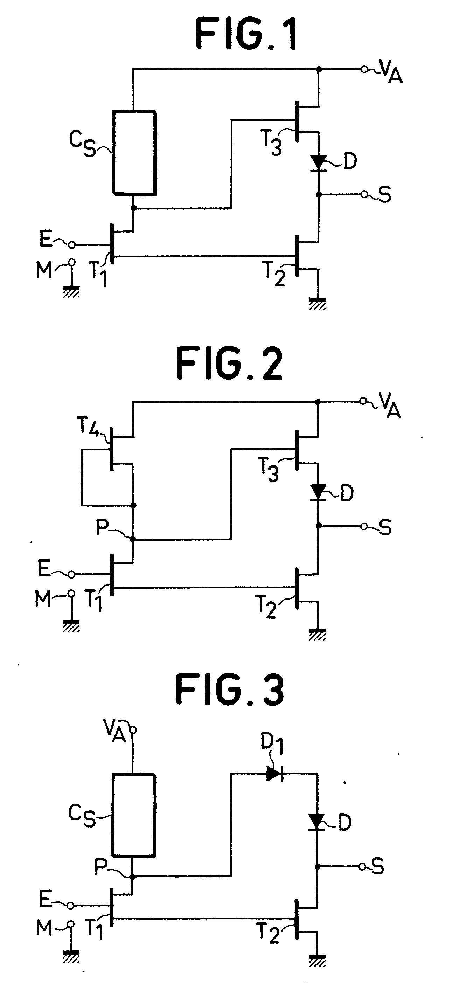

L'invention sera mieux comprise, et d'autres caractéristiques apparaîtront au moyen de la description qui suit, et des figures 1 à 3 représentant trois réalisations de l'invention.

Figure 1, on a représenté un inverseur logique comprenant trois transistors à effet de champ du type à faible tension de seuil défini ci-avant, soit $T_1$, $T_2$ et $T_3$. Le transistor $T_1$ a sa grille reliée à une borne E constituant avec la masse M l'entrée du circuit logique. La source de $T_1$ est reliée à la grille du transistor $T_2$ dont la source est à la masse.

Le drain de $T_1$ est relié à travers une charge saturable $C_S$ dont la nature sera précisée ci-après à un pôle $V_A$ d'une alimentation continue dont l'autre pôle est à la masse (source non représentée).

Le transistor $T_3$ a sa grille reliée en un point P connecté à la charge saturable et au drain $T_1$. Le drain de $T_3$ est relié au pôle $V_A$ et sa source au

drain de $T_2$ à travers une diode passante dans le sens allant de $V_A$ vers la masse, la sortie S de l'inverseur étant prise sur le drain de $T_2$. La charge saturable $C_S$ est soit une résistance saturable à structure à canal creusé, soit un transistor à effet de champ du type normalement débloqué dont la grille et la source sont reliées entre elles par un court-circuit. Ce cas particulier est représenté figure 2 où le transistor $T_4$, à court-circuit grille-source remplace $C_S$.

Le fonctionnement est le suivant : le transistor $T_2$ introduit entre masse et source du transistor $T_1$ une tension qui n'est autre que la tension de la diode Schottky du contact de grille, soit $V_{GS}$.

Cette tension $V_{GS}$, même pour un courant drain-source infime, est de l'ordre de 0,8 volt, donc non négligeable.

Il en résulte que l'on dispose d'une marge de 0,8 volt pour assurer le blocage du transistor $T_1$ lorsque l'entrée est dans l'état logique « 0 » (potentiel bas). En effet, dans le cas le plus défavorable où l'on aurait une tension du seuil fortement négative pour $T_1$, soit :

$$V_T = -0,5 \text{ volt}$$

et où le potentiel d'entrée de l'inverseur logique serait extrêmement bas, par exemple dans le cas où le transistor $T_2$ d'un étage identique, précédant l'inverseur, est lui-même bloqué, donc où la tension d'entrée est la tension résiduelle entre drain et source du transistor bloqué, soit :

$$V_E = V_{rés}$$

le transistor $T_1$ restera bloqué tant que :

$$V_{rés} - V_{GS} < V_T$$

$$V_{rés} < V_T + V_{GS}$$

$$V_{rés} < 0,3 \text{ volt}.$$

Cette condition est facilement réalisable.

Dans le cas du circuit de la figure 2, où la résistance saturable est remplacée par un transistor à effet de champ $T_4$, à court-circuit grille-source, la tension de seuil de $T_4$ doit être assez proche de 0 volt par exemple $-0,1$ volt comme valeur extrême, sinon on ne limite pas efficacement le courant dans le transistor $T_1$.

Figure 3, on a représenté une variante du circuit de la figure 1, dans laquelle on a supprimé le transistor $T_3$ que l'on a remplacé par une diode $D_1$ branchée, non plus entre $V_A$ et l'électrode d'entrée de D, mais entre le point P et la diode D. Cette diode est de même sens que la diode D.

Le fonctionnement de ce circuit est très semblable à celui de la figure 1.

Parmi les avantages non encore signalés de l'invention, on mentionnera le fait que la charge saturable du circuit logique peut être constituée avec un transistor à effet de champ dont la grille est reliée à la source par un court-circuit, sans recours à la technologie d'usinage ionique.

L'invention s'applique aux circuits logiques utilisant l'inverseur selon l'invention.

**Revendications**

1. Inverseur logique à bas niveau d'entrée, utilisant des transistors à effet de champ de type quasi normalement bloqué, à faible tension de seuil, caractérisé en ce qu'il comporte deux bornes d'entrée dont l'une (M) est reliée à la masse de l'inverseur et l'autre (E) est reliée à la grille d'un premier transistor ($T_1$) d'entrée à effet de champ du type quasi normalement bloqué à faible tension de seuil, dont la source est reliée à la masse de l'inverseur par l'intermédiaire d'un second transistor ($T_2$) à effet de champ du type quasi normalement bloqué à faible tension de seuil, la grille du second transistor ($T_2$) étant connectée à la source du premier transistor ($T_1$) et la source du second transistor ($T_2$) connectée à la masse, ce qui introduit pour le premier transistor ($T_1$) une tension de décalage égale à la tension de la diode de contact de grille ($V_{GS}$) du second transistor ($T_2$), le premier ($T_1$) et le second ($T_2$) transistors étant alimentés à partir d'un pôle d'alimentation continue ($V_A$) respectivement à travers une charge saturable ($C_S$) et à travers au moins une diode (D), la sortie (S) de l'inverseur étant prélevée entre la diode (D) et le drain du second transistor ($T_2$).

2. Inverseur suivant la revendication 1, caractérisé en ce qu'il comporte une première branche de circuit comprenant, entre le pôle d'alimentation ($V_A$) et la masse, la charge saturable ($C_S$), le drain et la source du premier transistor ($T_1$), la grille et la source du deuxième transistor ($T_2$) et une deuxième branche de circuit comprenant, entre les mêmes points, le drain et la source d'un troisième ($T_3$) transistor à effet de champ du type quasi normalement bloqué à faible tension de seuil, dont la grille est reliée au drain du premier transistor ($T_1$), la diode (D), le drain et la source du deuxième transistor ($T_2$).

3. Inverseur suivant la revendication 2, caractérisé en ce que la charge saturable ($C_S$) est une résistance saturable comportant une structure de transistor à effet de champ ($T_4$) présentant une tranchée entre source et drain.

4. Inverseur suivant la revendication 2, caractérisé en ce que la charge saturable ($C_S$) est un transistor à effet de champ ($T_4$) dont la grille est reliée à la source par un court-circuit.

5. Inverseur selon la revendication 1, caractérisé en ce qu'il comporte une première branche de circuit comprenant, entre le pôle d'alimentation ($V_A$) et la masse, la charge saturable ($C_S$), le drain et la source du premier transistor ($T_1$), la grille et la source du deuxième transistor ($T_2$) et une deuxième branche de circuit comprenant le deuxième transistor ($T_2$) et deux diodes (D, $D_1$) en série entre le drain du premier transistor ($T_1$) et le drain du deuxième transistor ($T_2$), les deux

diodes (D, D₁) étant passantes dans le sens allant du drain du premier transistor (T₁) au drain du deuxième (T₂), le drain du premier transistor étant relié au pôle d'alimentation continue à travers la charge saturable.

6. Circuit logique caractérisé en ce qu'il comporte un inverseur logique selon l'une des revendications 1 à 5.


**Claims**

1. Logical, low input level inverter using field effect transistors of normally substantially off type, and having a low threshold voltage, characterized in that it comprises a first, input transistor (T₁) the gate of which receives an input signal (E) and the source of which is connected to the ground (M) of the inverter through a second transistor (T₂), the gate of the second transistor (T₂) being connected to the source of the first transistor (T₁) and the source of the second transistor (T₂) being connected to ground (M), thereby introducing a shifting voltage of the first transistor (T₁) equal to the voltage of the gate contact diode (V_GS) of the second transistor (T₂), the first (T₁) and second (T₂) transistors being supplied from a current source (V_A) through a saturable load (C_S) and through at least one diode (D), respectively, the output (S) of the inverter being derived between the diode (D) and the drain of the second transistor (T₂).

2. Inverter according to claim 1, characterized in that it comprises a first circuit branch including, between the supply terminal (V_A) and ground (M), a saturable load (C_S), the drain and the source of the first transistor (T₁), the gate and the source of the second transistor (T₂), and a second circuit branch comprising, between the same terminals, the drain and the source of a third field effect transistor (T₃) the gate of which is connected to the drain of the first transistor (T₁), the diode (D), the drain and the source of the second transistor (T₂).

3. Inverter according to claim 2, characterized in that the saturable load (C_S) is a saturable resistor comprising a field effect transistor structure (T₄) having a trench between its source and drain.

4. Inverter according to claim 2, characterized in that the saturable load (C_S) is a field effect transistor (T₄) the gate of which is connected to the source through a short-circuit connection.

5. Inverter according to claim 1, characterized in that it comprises a first circuit branch including, between the supply terminal (V_A) and ground (M), a saturable load (C_S), the drain and the source of the first transistor (T₁), the gate and the source of the second transistor (T₂), and a second circuit branch comprising the second transistor (T₂) and two diodes (D, D₁) connected in series between the drain of the first transistor (T₁) and the drain of the second (T₂), the two diodes (D, D₁) being conductive in the direction from the drain of the first transistor (T₁) towards the drain of the second (T₂), the drain of the first transistor being connected to the direct supply through a saturable load.

6. Logical circuit, characterized in that it comprises a logical inverter in accordance with any of claims 1 to 5.


**Ansprüche**

1. Logischer Inverter mit niedrigem Eingangspegel, unter Verwendung von Feldeffekttransistoren vom normalerweise praktisch gesperrten Typ, mit geringer Schwellspannung, dadurch gekennzeichnet, daß er einen ersten bzw. Eingangstransistor (T₁) umfaßt, dessen Gate das Eingangssignal (E) empfängt und dessen Source-Elektrode mit der Masse (M) des Inverters über einen zweiten Transistor (T₂) verbunden ist, wobei das Gate des zweiten Transistors (T₂) mit der Source-Elektrode des ersten Transistors (T₁) und die Source-Elektrode des zweiten Transistors (T₂) mit Masse (M) verbunden ist, wodurch für den ersten Transistor (T₁) eine Verschiebespannung eingeführt wird, die gleich der Spannung der Gatekontaktdiode (V_GS) des zweiten Transistors (T₂) ist, wobei der erste (T₁) und der zweite Transistor (T₂) von einer Stromquelle (V_A) über eine sättigbare Last (C_S) bzw. über wenigstens eine Diode (D) gespeist werden, und wobei der Ausgang (S) des Inverters zwischen der Diode (D) und der Drain-Elektrode des zweiten Transistors (T₂) abgegriffen ist.

2. Inverter nach Anspruch 1, dadurch gekennzeichnet, daß er einen ersten Schaltungszweig umfaßt, der zwischen dem Speisepol (V_A) und Masse (M) eine sättigbare Last (C_S), die Drain- und die Source-Elektrode des ersten Transistors (T₁), das Gate und die Source-Elektrode des zweiten Transistors (T₂) sowie einen zweiten Schaltungszweig enthält, der zwischen denselben Punkten die Drain- und die Source-Elektrode eines dritten Feldeffekttransistors (T₃), dessen Gate mit der Drain-Elektrode des ersten Transistors (T₁) verbunden ist, die Diode (D), die Drain- und die source-Elektrode des zweiten Transistors (T₂) umfaßt.

3. Inverter nach Anspruch 2, dadurch gekennzeichnet, daß die sättigbare Last (C_S) ein sättigbarer Widerstand ist, der eine Feldeffekttransistorstruktur (T₄) enthält, welche einen Graben zwischen der Source- und der Drain-Elektrode aufweist.

4. Inverter nach Anspruch 2, dadurch gekennzeichnet, daß die sättigbare Last (C_S) ein Feldeffekttransistor (T₄) ist, dessen Gate mit der Source-Elektrode durch eine Kurzschlußverbindung verbunden ist.

5. Inverter nach Anspruch 1, dadurch gekennzeichnet, daß er einen ersten Schaltungszweig umfaßt, welcher zwischen dem Speisepol (V_A) und Masse (M) eine sättigbare Last (C_S), die Drain- und die Source-Elektrode des ersten Transistors (T₁), das Gate und die Source-Elektrode des zweiten Transistors (T₂) enthält, und einen zweiten Schaltungszweig umfaßt, welcher den zweiten Transistor (T$_2$) und zwei Dioden (D, D$_1$) umfaßt, die in Reihe zwischen der Drain-Elektrode des ersten Transistors (T$_1$) und der Drain-Elektrode des zweiten (T$_2$) liegen, wobei die beiden Dioden (D, D$_1$) in Richtung von der Drain-Elektrode des ersten Transistors (T$_1$) zur Drain-Elektrode des zweiten (T$_2$) stromdurchlässig sind und wobei die Drain-Elektrode des ersten Transistors mit der Gleichspeisung über eine sättigbare Last verbunden ist.

6. Logikschaltung, dadurch gekennzeichnet, daß sie einen logischen Inverter nach einem der Ansprüche 1 bis 5 umfaßt.

# FIG.1

# FIG.2

# FIG.3